# EUROPÄISCHE PATENTANMELDUNG

(11) **EP 2 404 697 A1**
(43) Veröffentlichungstag der Anmeldung: **11.01.2012**
(21) Anmeldenummer: 11005574.6
(22) Anmeldetag: 07.07.2011
(51) Int. Cl.: B23K 26/18, B23K 26/36, B23K 26/40, H01L 27/142, H01L 31/0224

(54) **Verfahren zum Materialabtrag an Festkörpern mit Herabsetzen der zeitlichen und/oder räumlichen Kohärenz der Laserstrahlung**

(30) Priorität: 07.07.2010 DE 102010026331
(71) Anmelder: Fraunhofer-Gesellschaft zur Förderung der angewandten Forschung e.V., 80686 München (DE)
(72) Erfinder: Knorz, Annerose, 79102 Freiburg (DE); Preu, Ralf, 79117 Freiburg (DE); Peters, Marius, 588195 Singapore (SG); Hauser, Hubert, 79106 Freiburg (DE); Bläsi, Benedikt, 79104 Freiburg (DE)
(74) Vertreter: Pfenning, Meinig & Partner GbR

(57) **Zusammenfassung**

Die vorliegende Erfindung betrifft ein Verfahren zum Materialabtrag an Festkörpern durch Laserablation, bei dem die räumliche und/oder zeitliche Kohärenz der Laserstrahlung vor dem Schritt der Materialbearbeitung, d.h. vor und/oder unmittelbar beim Auftreffen der Laserstrahlung auf dem zu bearbeitenden Festkörper herabgesetzt wird.

## Beschreibung

Die vorliegende Erfindung betrifft ein Verfahren zum Materialabtrag an Festkörpern durch Laserablation, bei dem die räumliche und/oder zeitliche Kohärenz der Laserstrahlung vor dem Schritt der Materialbearbeitung, d.h. vor und/oder unmittelbar beim Auftreffen der Laserstrahlung auf dem zu bearbeitenden Festkörper herabgesetzt wird.

Für verschiedene Anwendungen bei der Herstellung von Solarzellen wird eine lokale schädigungsarme Öffnung in einer dielektrischen Schicht auf einer texturierten Oberfläche benötigt.

Mögliche Anwendungsgebiete sind dabei u.a.:
- Vorderseitenmetallisierung von Halbleitersubstraten
- Rückseitenmetallisierung von Halbleitersubstraten
- Lokale Öffnung einer Diffusionsbarriere
- Lokale Öffnung einer Ätzbarriere

### Stand der Technik

### Kontaktierung auf der Vorderseite

### 1. Industrieller Standardprozess:

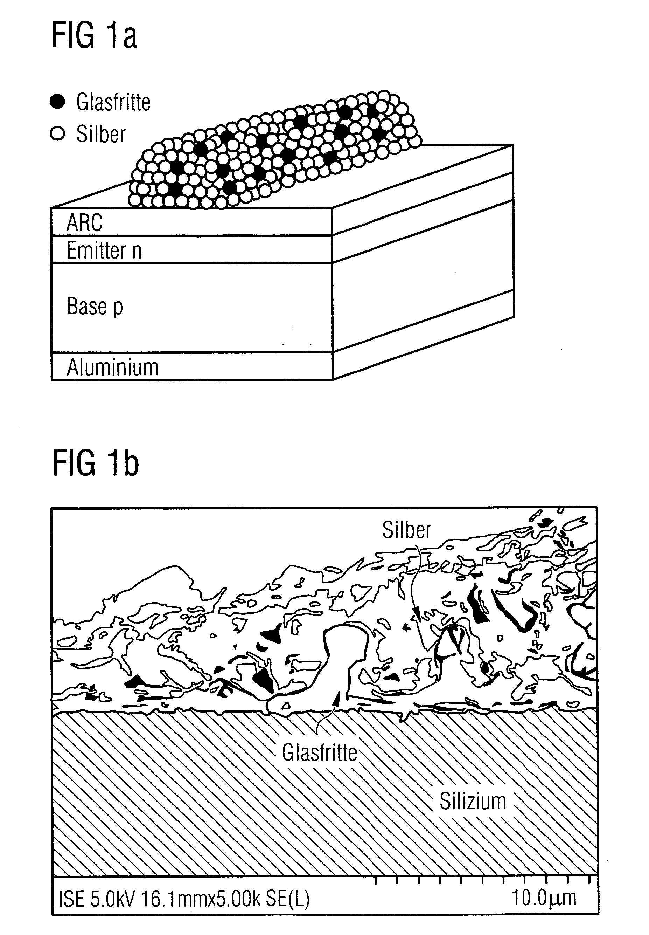

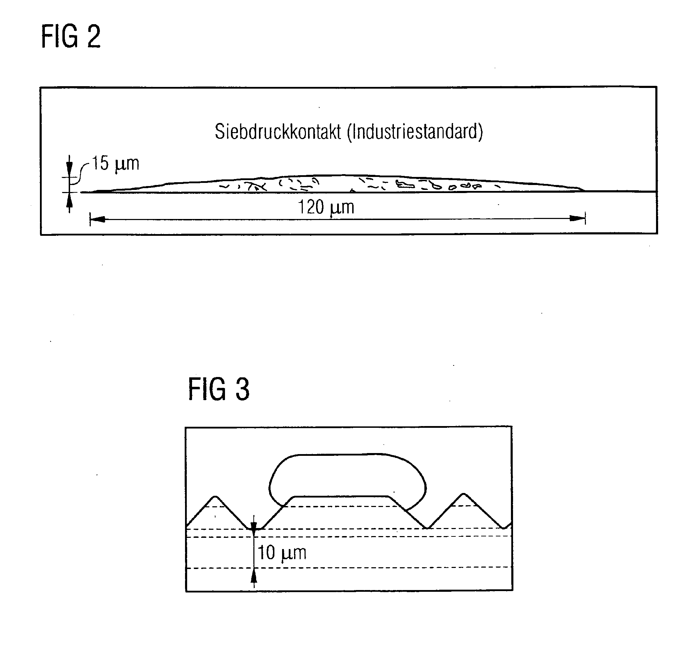

Das Standardverfahren für die Vorderseitenmetallisierung von industriell gefertigten Solarzellen besteht im Druck einer silberhaltigen Paste in der angestrebten Kontaktstruktur auf die Antireflex-Schicht der Solarzelle (siehe Fig. la, die schematisch einen siebgedruckten Kontakt darstellt. Fig. 1b zeigt eine REM-Aufnahme eines Kontaktquerschnitts nach dem Feuerschritt mit der isolierenden Siliziumoxid-Schicht zwischen Silber und Silizium aus Frittenresten. Der Kontakt zwischen Metall und Halbleiter wird allein durch die dünnen Silberkristallite gebildet). Die Paste enthält Glasfritten, welche aus einigen Mikrometer großen Silikat-Glas- oder Bleioxid-Plättchen bestehen und einen Schmelzpunkt bei ca. 700 °C besitzen. Während des Feuerschritts nach dem Drucken schmilzt die Glasfritte und entfernt über eine Redoxreaktion die Antireflex-Schicht über dem Silizium. Bei dieser Reaktion entsteht Blei, welches sich mit dem flüssigen Silber vermischt und Silberkristallite ausbildet. Siliziumoxid als weiteres Reaktionsprodukt liegt als isolierende Schicht zwischen Silizium und dem Silberkontakt und wird nur an wenigen Stellen durch die Kristallite durchbrochen, welche somit allein den Kontakt zwischen Silizium und Metall ausbilden (siehe die in Fig. 1b dargestellte elektronenmikroskopische Aufnahme). Aufgrund der geringen Kontaktfläche ist ein geringer Kontaktwiderstand notwendig, um den Gesamtwiderstand klein zu halten. Dieser kann bei Silber aufgrund der großen Austrittsarbeit nur über eine hohe Emitterdotierung erreicht werden und wirkt sich somit limitierend auf den Wirkungsgrad der Solarzelle aus. Weiterhin bedingt die geringe Kontaktfläche zwischen Silber und Silizium, dass es bei abnehmender Fingerbreite leicht zur Unterbrechung der Kontakte kommt. Eine Reduzierung der Kontaktfläche und Abschattung der aktiven Zellfläche ist daher mit Siebdruckkontakten nur begrenzt möglich. Die minimale Strukturgröße, bei welcher noch keine Unterbrechung in den Kontaktfingern auftritt liegt bei ca. 70 µm. Bei der industriellen Fertigung von Solarzellen liegen die Strukturbreiten bei ca. 120 µm nach dem Druck, wobei die Kontakte während des Hochtemperaturschritts durch thermisch bedingtes Verlaufen weiter verbreitern. Dieses Verlaufen führt gleichzeitig zu einem Abflachen der Kontakte, wodurch ein schlechtes Verhältnis aus Kontakthöhe zu Kontaktbreite, dem so genannten Aspektverhältnis, entsteht (siehe Fig. 2 zeigt eine REM-Aufnahme eines siebgedruckten Kontaktfingers im Querschnitt). Typische Aspektverhältnisse für siebgedruckte Kontakte liegen im Bereich 1:10.

Da die Antireflex-Schicht bei der Siebdruck-Kontaktierung durch das Schmelzen der Glasfritten geöffnet wird, kann dieses Verfahren nicht auf einen Hochtemperaturschritt verzichten. Die hohen Temperaturen zerstören jedoch die passivierende Wirkung vieler Materialien, wie beispielsweise von amorphem Silizium, wodurch eine Passivierung der Rückseite für Industrie-Solarzellen mit Siebdruckkontakten schwer realisierbar ist. Als weiteren Nachteil des Siebdruckverfahrens ist die mechanische Belastung der Wafer und die damit verbundene Bruchrate zu erwähnen. Trotz dieser zahlreichen Nachteile konnte sich die Siebdruck-Kontaktierung aufgrund der geringen Anzahl an Prozessschritten und den hohen Durchsatzraten in der Industrie durchsetzen.

### 2. Kontaktierung für hocheffiziente Labor-Solarzellen:

Bei der Kontaktierung von hocheffizienten Solarzellen werden photolithographisch definierte Kontaktstrukturen nasschemisch in die Antireflex-Schicht geätzt und anschließend Metallkontakte bestehend aus Titan, Palladium und Silber aufgedampft. Die Definition der Kontaktstellen erfolgt photolithographisch durch die Belichtung der mit Photolack beschichteten Solarzelle durch eine Maske. Der belichtete Lack wird ausgelöst und die freiliegende Antireflex-Schicht durch nasschemisches Ätzen in konzentrierter Flusssäure entfernt. Im Folgenden wird eine dünne TiPdAg-Schicht ganzflächig auf die Oberfläche aufgedampft, welche schon ohne Hochtemperaturschritt einen guten Kontakt zwischen Silizium und Metallkontakt ausbildet. Der Photolack wird nun entfernt, wobei auch die Metallschicht von Oberfläche entfernt wird. Die verbleibenden dünnen Kontakte werden galvanisch verstärkt, wobei das kugelförmige Verstärkungsprofil ein ideales Aspektverhältnis von eins ermöglicht. In der Realität werden Aspektverhältnisse von ca. 1:3 erreicht (siehe z.B. Fig. 3, die eine REM-Aufnahme eines aufgedampften und galvanisch verstärktem Vorderseitenkontakts im Querschnitt zeigt). Die Strukturgrößen bei der photolithographischen Öffnung sind prinzipiell nur über die Wellenlänge begrenzt und die Kontaktbreite wird allein durch die Anforderungen an den Serienwiderstand bestimmt. Aufgrund des geringen Kontaktwiderstands durch die großflächige Öffnung der Antireflex-Schicht und der geringen Austrittsarbeit von Titan sind nur kleine Kontaktstrukturen notwendig, wodurch nur geringe Abschattungsverluste erzeugt werden. Durch den geringen Kontaktwiderstand entfallen Anforderungen an das Emitterprofil, wodurch der Wirkungsgrad nicht begrenzt wird. Da der gesamte Metallisierungsprozess kontaktlos abläuft, wird die Solarzelle während der Prozessierung nicht geschädigt. Trotz dieser zahlreichen Vorteile ist dieses Verfahren aufgrund der Vielzahl an kostenintensiven Prozessschritten industriell nicht einsetzbar.

### 3. Alternative Vorderseiten-Metallisierung mit Laserablation:

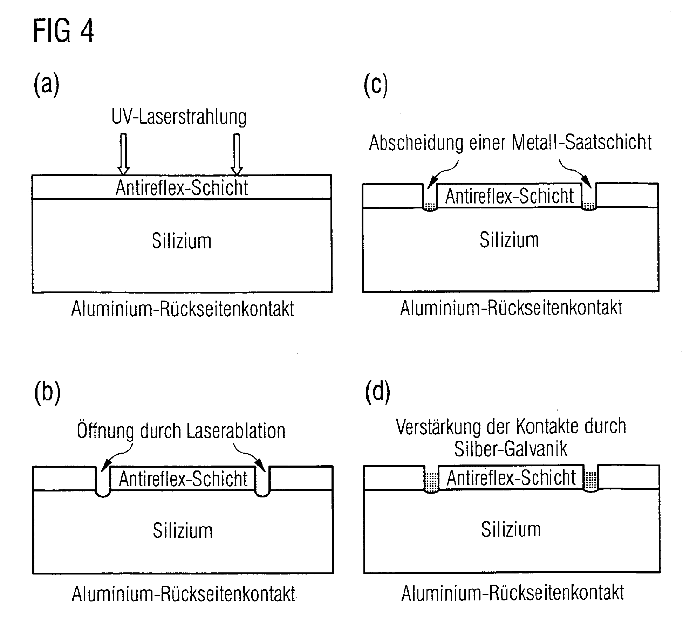

Eine schädigungsarme Laserablation der Antireflex-Schicht auf der Vorderseite könnte die Basis eines neuartigen Kontaktierungsverfahren sein, welches die Vorteile der hocheffizienten Kontaktierung birgt und aufgrund weniger Prozessschritte industriell realisierbar ist (siehe Fig. 4 - Schematische Darstellung eines auf Laserablation basierenden Vorderseitenprozesses). In Fig. 4a ist eine Solarzelle dargestellt, deren Antireflex-Schicht auf der Vorderseite lokal mit UV-Laserlicht bestrahlt wird. Durch Laserablation wird die Antireflexschicht geöffnet (Fig. 4b). In diese Öffnungen wird zum Beispiel durch Nickel-Plating eine dünne Saatschicht abgeschieden (Fig. 4c), welche zu durch Silber-Galvanik zu Kontakten verstärkt wird (Fig. 4d). Das Prozessschema dieser neuen Vorderseitenmetallisierung ist stark an das hocheffiziente Kontaktierungsprinzip angelehnt, wobei die aufwändigen und zahlreichen Schritte zur Kontaktdefinition durch Photolithographie und nasschemisches Ätzen durch einen Schritt, die Laserablation, ersetzt werden. Nachdem die Antireflex-Schicht mit dem Laser geöffnet wurde (Fig. 4a und 4b), kann z.B. eine metallische Saatschicht z.B. mittels Nickel-Galvanik lokal abgeschieden werden (Fig. 4c) und anschließend ggf. mit Silber- oder Kupfergalvanik verstärkt werden (Fig. 4d). Die Laserablation ist ein kontaktloser Prozess, bei dem keine mechanische Belastung auf den Wafer ausgeübt wird. Die Strukturbreite der Öffnungen wird durch den Laserstrahl begrenzt und liegt in einem Bereich von ca. 5 µm bis 20 µm. Durch die großflächige Öffnung der dielektrischen Schicht auf der Vorderseite und den Einsatz von Metallen mit kleinen Austrittsarbeiten verringert sich die Anforderung an die Dotierung des Emitters.

Für eine erfolgreiche Realisierung dieses Verfahrens muss die Laserablation folgenden Ansprüchen genügen:
- Die laserinduzierte Schädigung darf die Lebensdauer der Ladungsträger im Emitter nicht signifikant verkleinern, so dass die Leerlaufspannung der Solarzelle unbeeinflusst bleibt.
- Der Materialabtrag muss möglichst auf die Antireflex-Schicht begrenzt sein, um Schädigungen in der Raumladungszone und Kurzschlüsse der Solarzelle zu vermeiden (siehe Abbildung).
- Die Öffnung der dielektrischen Schicht muss ausreichend groß sein, um die Serienwiderstände klein zu halten und eine durchgehende Metallisierung zu ermöglichen. Anderseits sind kleine Strukturgrößen für geringe Abschattungsverluste wünschenswert.

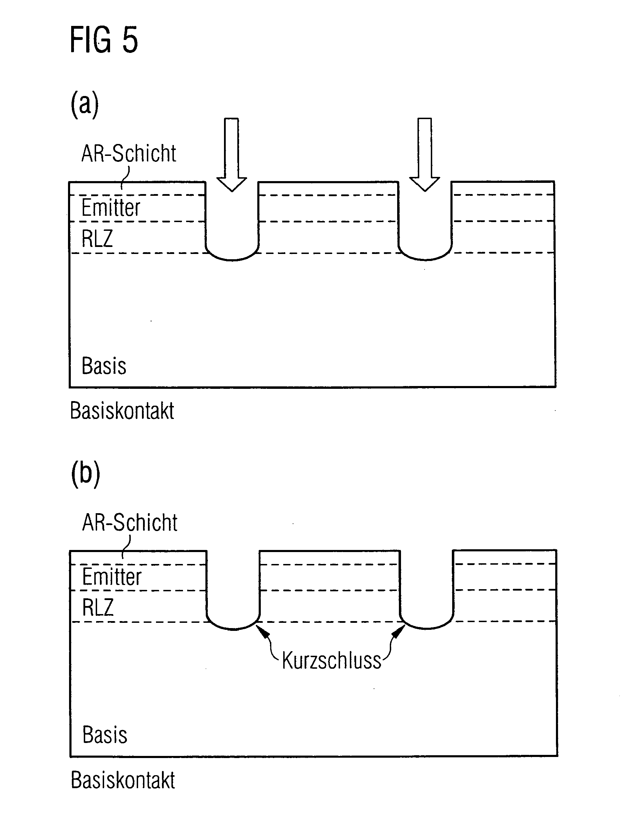

Figur 5 zeigt eine schematische Darstellung der Kurzschlusserzeugung bei der Laserablation, die es zu vermeiden gilt. Werden bei der Laserablation der Antireflex-Schicht zusätzlich größere Mengen an Silizium abgetragen (a), so kann es nach der Metallabscheidung zu einem Kurzschluss der Solarzelle kommen, der sich als Parallelwiderstand in den Kennlinien der Solarzelle erkenntlich macht.

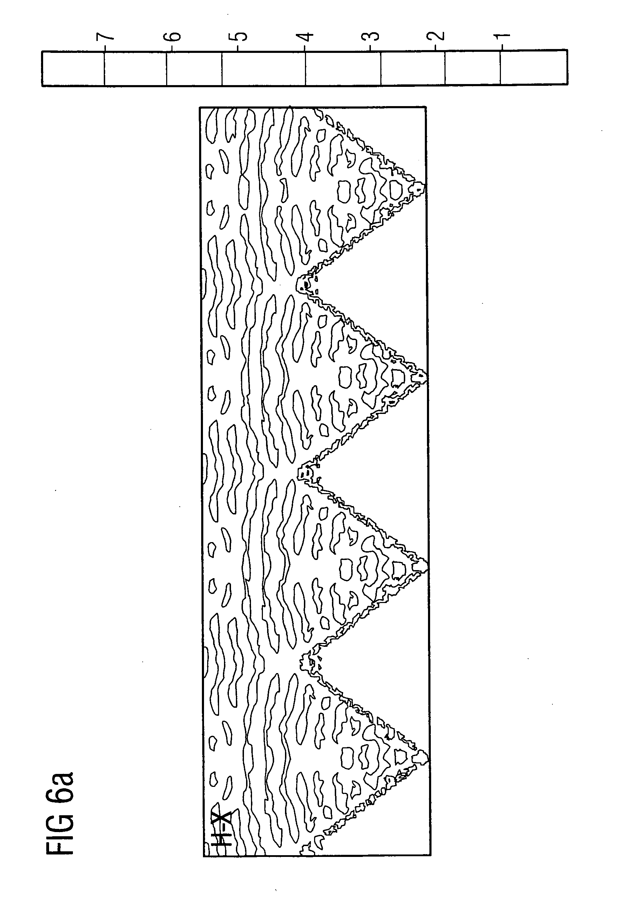

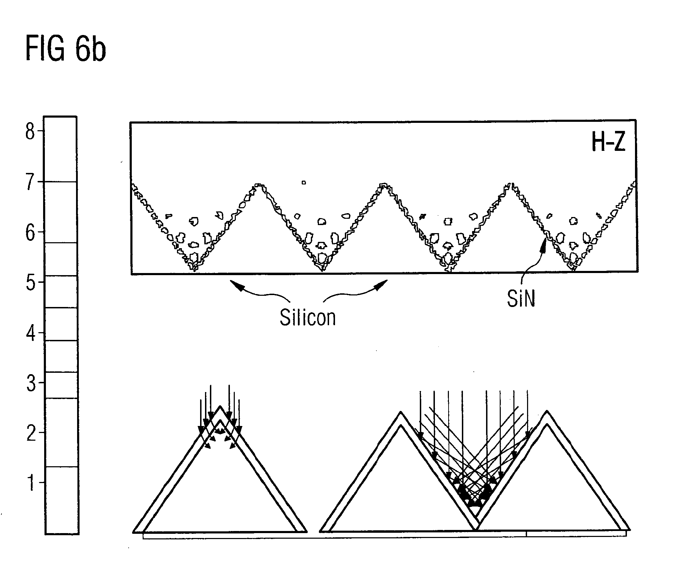

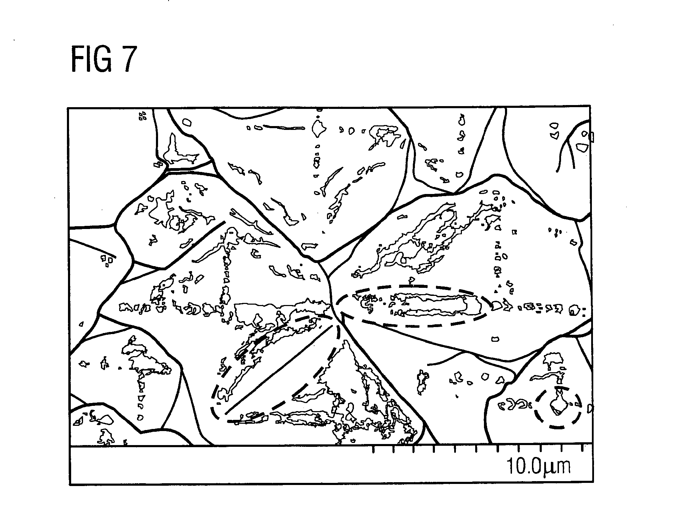

Sobald jedoch eine (dielektrische) Schicht auf einer regelmäßig geformten Oberfläche mit einem Laser strukturiert werden soll, treten durch die Kombination aus kohärentem Licht und regelmäßigen Strukturen (Pyramiden) ein Interferenzmuster und lokale Erhöhungen im elektromagnetischen Feld durch Brechungs- und Sammlungseffekte auf (siehe Fig. 6a und 6b). Fig. 6a und 6b zeigen Ergebnisse aus RCWA (Rigorous Coupled Wave Analysis) - Simulationen zeigen lokale Erhöhungen im elektromagnetischen Feld, die durch Reflexion an den Seitenwänden und Brechung der einfallenden Strahlen hervorgerufen werden. In der unteren Abbildung sind die Sammlungs- und Brechungseffekte, die neben dem auftretenden Interferenzmuster zu einer inhomogenen Intensitätsverteilung führen, dargestellt. Diese lokalen Erhöhungen bewirken eine inhomogene Intensitätsverteilung und bedingen eine erhöhte Schädigung im Silizium (siehe Fig. 7). Fig. 7 zeigt eine REM-Aufnahme einer texturierten und mit Siliziumnitrid beschichteten Siliziumoberfläche. Das Siliziumnitrid wurde mit einem einzelnen Laserpuls entfernt, wobei aufgrund der inhomogenen Intensitätsverteilung ein vermehrter Abtrag zwischen den Pyramiden und an den Spitzen der Pyramiden zu beobachten ist. Die geschädigten Bereiche sind in Fig. 7 eingekreist dargestellt.

Bei niedrigen Intensitäten wird die Oberfläche nur noch an den Stellen geöffnet, an denen die oben genannten Effekte lokale Maxima in der Intensitätsverteilung erzeugen. Damit erhöht sich die Gefahr, dass der nachfolgende Prozessschritt z.B. eine Metallisierung des geöffneten Bereiches abreißt oder einen erhöhten Serienwiderstand aufweist.

Ausgehend von den oben angesprochenen Problematiken ist es daher Aufgabe der vorliegenden Erfindung, ein effizientes Verfahren zum Materialabtrag an Festkörpern, insbesondere an Siliziumwafern und/oder Solarzellen, anzugeben, das zum einen eine effiziente Vorgehensweise erlaubt, zum anderen eine Schädigung der Oberfläche, insbesondere einer strukturierten Oberfläche, vermeidet.

Diese Aufgabe wird mit den Merkmalen des Patentanspruchs 1 gelöst. Die abhängigen Patentansprüche stellen dabei vorteilhafte Weiterbildungen dar.

Erfindungsgemäß wird somit ein Verfahren zum Materialabtrag an Festkörpern mittels Laserablation bereitgestellt, bei dem die räumliche und/oder zeitliche Kohärenz der zum Materialabtrag eingesetzten Laserstrahlung vor und/oder unmittelbar beim Auftreffen auf den Festkörper herabgesetzt wird.

Die Kohärenzlänge wird dadurch herabgesetzt, dass Phaseninformation zerstört wird, resp. Licht mit einer großen Anzahl an unkorellierten Phasen erzeugt wird. Das erfindungsgemäße Verfahren ist insbesondere dann erfolgreich, wenn die Kohärenzlänge nach Streuung so klein ist, dass sie deutlich unterhalb der relevanten Perioden oder Schichtdicken, die auftreten ist.

Das erfindungsgemäße Verfahren kann zur Strukturierung bzw. zum Materialabtrag aller möglichen Oberflächen angewendet werden. Besonders bevorzugt können mit dem erfindungsgemäßen Verfahren Oberflächen bearbeitet werden, die mit mehreren Schichten beschichtet sind. Hierbei kann es ebenso zu dem oben angesprochenen nachteiligen Interferenzeffekten bei einer Materialablation durch Laser kommen.

Ein besonderer Vorteil ergibt sich dann, wenn die auf der Waferoberfläche vorhandenen Strukturen zu einer Überlagerung der elektromagnetischen Wellen führen würden, die an der Waferoberfläche oder im Wafer selbst zu Intensitätsverstärkung- oder Reduktion führen, insb. wenn diese substanziell sind (bspw. Faktor 2 oder größer, siehe Fig. 6 und 7). Dies ist sicherlich gegeben für pyramidenartige Strukturen aber auch für andere Strukturen, die für die verbesserte Lichteinkopplung in Waferoberflächen eine Rolle spielen können, bspw. wabenartige Strukturen. Bevorzugt sollten die Strukturgrößen kleiner sein als die Kohärenzlänge.

Der besondere Vorteil des erfindungsgemäßen Verfahrens ist somit darin zu sehen, dass insbesondere bei strukturierten Oberflächen bzw. bei Oberflächen, die mehrere Beschichtungen aufweisen, Interferenzen des eingesetzten Laserlichts (das normalerweise eine sehr hohe Kohärenzlänge aufweist) vermieden werden können, indem die Kohärenzlänge des verwendeten Laserlichts beispielsweise durch diffuse Streueffekte herabgesetzt wird. Das erfindungsgemäße Verfahren ermöglicht daher auch bei den oben angesprochenen strukturierten Oberflächen bzw. Oberflächen, die mehrere Beschichtungen aufweisen, einen möglichst gleichmäßigen Materialabtrag. Daher können Schädigungen von Oberflächen (siehe hierzu insbesondere Figur 7), wie sie aus dem Stand der Technik bekannt sind, vollständig vermieden werden.

In einer bevorzugten Ausführungsform wird die räumliche und/oder zeitliche Kohärenz der Laserstrahlung
a) durch Transmission der Laserstrahlung durch ein die Laserstrahlung streuendes Medium,
b) durch Reflexion der Laserstrahlung an einem die Laserstrahlung streuenden Medium und/oder
c) durch relative Bewegung der Quelle der Laserstrahlung und des Festkörpers während des Ablationsvorganges
herabgesetzt.

Das zuvor angesprochene streuende Medium ist dabei bevorzugt ausgewählt aus der Gruppe bestehend aus die Laserstrahlung streuenden Partikeln oder partikelhaltigen Systemen, insbesondere in Form von die Laserstrahlung streuenden Pulvern oder Dispersionen und/oder Emulsionen und/oder Lösungen der Partikel.

Weiter ist es bevorzugt, wenn die räumliche und/oder zeitliche Kohärenz der Laserstrahlung durch Reflexion der Laserstrahlung an einem die Laserstrahlung streuenden Medium z.B. durch Reflexion an einer geeigneten Platte herabgesetzt wird. Bei dieser bevorzugten Ausführungsform wird das eingesetzte Laserlicht vor Auftreffen auf das zu bearbeitende Substrat an einer hierfür geeigneten Platte diffus reflektiert und weiter bevorzugt im Anschluss an diese diffuse Reflexion wieder auf das zu bearbeitende Substrat fokussiert. Auch hierbei geht die räumliche und/oder zeitliche Kohärenz der eingesetzten Laserstrahlung im Wesentlichen verloren.

Die oben genannten Partikel, die beispielsweise als Pulver oder in Form einer Dispersion und/oder Emulsion bzw. Lösung eingesetzt werden können, sind dabei insbesondere SiO₂- oder TiO₂-Partikel oder Gemische hiervon.

Der bevorzugte mittlere Teilchendurchmesser d₅₀ der eingesetzten Partikel liegt dabei zwischen dem 0,1-und 10-fachen, bevorzugt zwischen dem 0,3- und 3-fachen, besonders bevorzugt zwischen dem 0,5- und 1-fachen der Wellenlänge des verwendeten Laserlichts.

Die Partikel können sowohl mono- als auch polydispers sein, hier sind keine Einschränkungen gesetzt. Die Geometrie der Partikel ist nicht entscheidend.

Vorteilhaft ist weiterhin, wenn vor der Laserablation die Partikel als Pulver oder Dispersion auf die zu bearbeitende Oberfläche des Festkörpers aufgetragen werden.

Im Falle der Verwendung einer Dispersion der oben genannten Partikel kann diese vorzugsweise durch Spin-Coating und/oder Dip-Coating aufgetragen werden, ebenso ist ein Aufsprühen der Dispersion möglich.

Das dispersive Medium kann auch aus einem Pulver, einer Suspension oder einer Flüssigkeit bestehen.

Insbesondere eignet sich das erfindungsgemäße Verfahren für den Fall, dass der Festkörper zumindest in dem Bereich, in dem der Materialabtrag durchgeführt wird, zumindest stellenweise eine regelmäßig strukturierte Oberfläche aufweist, insbesondere eine pyramidenförmige Strukturierung. Eine derartige pyramidenförmige Strukturierung ist beispielsweise auch in den Figuren 5 und 6 dargestellt. Eine derartige pyramidenförmige Strukturierung kommt beispielsweise bei Solarzellen regelmäßig zum Einsatz.

Bevorzugt eignet sich das Verfahren dann, wenn die Strukturierung eine Periodizität zwischen 1 und 100 µm, bevorzugt zwischen 5 und 50 µm, insbesondere zwischen 5 und 15 µm aufweist.

Im Falle einer pyramidenförmigen Strukturierung ist beispielsweise unter der Periodizität der Strukturierung der Abstand zweier Pyramidenspitzen voneinander zu verstehen. Maßgeblich ist hierbei das wiederkehrende Muster der Strukturierung, mit der die oben angegebene Periodizität ausgedrückt wird.

Insbesondere ist bevorzugt, wenn der Festkörper ein Halbleiter, bevorzugt ein Siliziumwafer, insbesondere eine eine Antireflexbeschichtung aufweisende Solarzelle ist, wobei der Materialabtrag auf der die Antireflexbeschichtung aufweisende Seite der Solarzelle erfolgt.

Die bevorzugt verwendete Laserstrahlung weist die folgenden vorteilhaften Charakteristika auf:
a) Eine Pulslänge zwischen 200 fs und 1000 ns, bevorzugt zwischen 400 fs und 100 ns,
b) eine Wellenlänge zwischen 100 und 10.000 nm, bevorzugt 150 und 5.000 nm, besonders bevorzugt zwischen 193 und 1.064 nm, und/oder
c) eine Intensität zwischen 0,1 und 10.000 kJ/m², bevorzugt zwischen 1 und 1.000 kJ/m², besonders bevorzugt zwischen 1 und 100 kJ/m^{2.}

Eine weitere vorteilhafte Ausführungsform des Verfahrens sieht vor, dass mindestens zwei Laser verwendet werden, deren Wellenlängen bevorzugt kein rationales Verhältnis bilden.

Eine weitere vorteilhafte Ausführungsform des Verfahrens sieht vor, dass mindestens zwei Laser mit verschiedenen Wellenlängen verwendet werden, wobei ausgehend von einem Zustand gleicher erster Phase aller Wellen frühestens nach dem 5-fachen, bevorzugt frühestens nach dem 25-fachen, besonders bevorzugt frühestens nach dem 50-fachen der Periode je einer Welle mit einer kleineren Wellenlänge diese Welle erneut den gleichen Zustand erster Phase gemeinsam mit allen Wellen größerer Wellenlänge aufweist.

Bei dem verwendeten irrationalen Verhältnis der Wellenlängen der verwendeten Laserstrahlung der mindestens zwei Laser wird vermieden, dass sich durch das Überlagern der Laserstrahlung erneut lokale Maxima oder Minima entstehen.

Bevorzugte Laser, die eingesetzt werden können, sind dabei ausgewählt aus der Gruppe bestehend aus CO₂ Lasern, HeNe-Lasern, Excimer-Lasern, Farbstofflasern, Diodenlasern, Faserlasern und/oder Festkörperlasern.

Weiter bevorzugt wird nach dem Materialabtrag eine zumindest teilweise Befüllung des beim Materialabtrag entstandenen Hohlraumes mit einem elektrisch leitfähigen Material durchgeführt.

Die Erfindung wird anhand der nachfolgenden Beschreibung sowie den beigefügten Figuren näher erläutert, ohne die Erfindung auf die dargestellten Ausführungsformen zu beschränken.

Um eine erhöhte Schädigung im Silizium aufgrund der lokalen Überhöhungen im elektromagnetischen Feld zu verhindern muss die verwendete Laserstrahlung möglichst inkohärent auf der zu strukturierenden Schicht treffen.

Dies kann über verschiedene Ansätze erreicht werden:

### 1. Zerstörung der Kohärenz mittels refraktiven Medien:

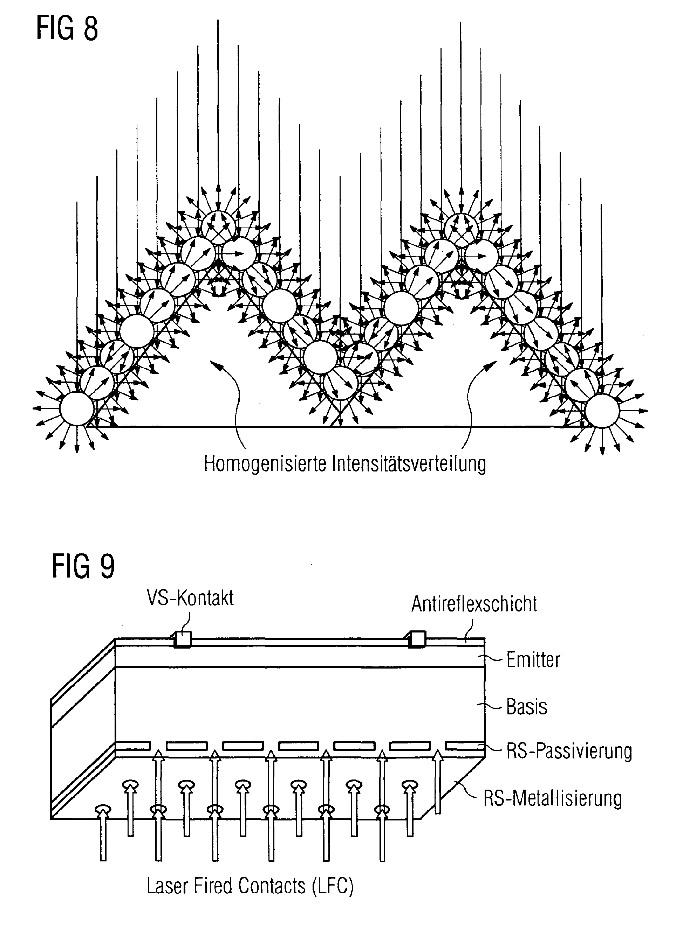

Um die räumliche und/oder zeitliche Kohärenz der einfallenden Laserstrahlung zu stören wird ein streuendes Medium z.B. eine streuende Flüssigkeit (Emulsion) oder wie in Fig. 8 (schematische Darstellung der Störung der Kohärenz von senkrecht einfallender Laserstrahlung auf einer regelmäßig texturierten Oberfläche durch ein streuendes Medium) dargestellt, Partikel, z.B. Kugeln, auf die Oberfläche ein- oder mehrlagig aufgebracht. Das einfallende Licht wird an diesen Objekten in alle Richtungen gestreut. Dadurch wird die räumliche und/oder zeitliche Kohärenz des Lichts zerstört und die lokalen Überhöhungen werden kleinräumiger und ihre Amplitude verringert. Ist das streuende Medium gleichzeitig lumineszent, d.h. es absorbiert einen Teil der einfallenden Strahlung und emittiert mit einer anderen Wellenlänge, kann auch eine Zerstörung der zeitlichen Kohärenz erzeugt werden. Dadurch würden die lokalen Überhöhungen weiter abgeschwächt werden.

Ausführungsmöglichkeit einer streuenden Schicht:
- Partikel an Luft oder in Medium.
- Partikel variierender Größe können auf die Probe aufgebracht werden, wodurch Kosten sinken (nicht monodispers).
- Materialien z.B. SiO₂, TiO₂

### 2. Störung der Kohärenz durch Bewegung der Probe

Eine weitere Möglichkeit, die räumliche und/oder zeitliche Kohärenz zu stören besteht darin, die zu bearbeitenden Proben während der Bestrahlung mit dem Laser zu bewegen. Wird die Probe während eines Laserpulses so weit bewegt, dass die Phasenkorrelation des auftreffenden Lichtes während des Pulses verloren geht, wird Interferenz und lokale Überhöhungen verhindert.

### 3. Einsatz von Laserquellen mit sehr geringen Kohärenzlängen

Durch die Verwendung von Laserquellen mit einer geringen Kohärenzlänge wie Excimer-Lasern kann ebenfalls eine Erniedrigung lokalen Erhöhungen und der damit erhöhten Schädigung im Substrat führen.

### 4. Zerstörung der Kohärenz im Strahlengang

Die Kohärenz der Laserstrahlung kann auch bereits vor dem Auftreffen der Strahlung auf die Probe zerstört werden z.B. einer refraktiven oder streuenden Platte in den Strahlengang.

### 5. Überlagerung mehrere Lichtquellen

Die Kohärenz lässt sich ebenfalls zerstören, wenn Licht aus mehreren Quellen (mit unterschiedlicher Wellenlänge) und mit unterschiedlichem Phasengang oder unterschiedlicher räumlicher Ausrichtung auf die Probe trifft.

Im Folgenden werden beispielhaft Anwendungsbereiche des erfindungsgemäßen Verfahrens beschrieben.

Lokale Kontaktierung auf der Rückseite:

### 1. Kontaktierung durch LFC:

Die lokale Kontaktierung der Rückseite kann auch mittels lokalem Laserfeuern durchgeführt werden. Dabei wird im Idealfall mit einzelnen Laserpulsen das Aluminium lokal aufgeschmolzen und durch die Passivierung hindurch ins Silizium einlegiert, so dass einen elektrischer Kontakt zwischen Rückseitenmetallisierung und der Basis der Solarzelle entsteht (siehe Fig. 9, die die Rückseitenkontaktierung einer PERC-Solarzelle mittels LFC darstellt). Beim Einsatz des erfindungsgemäßen Verfahrens lassen sich hierbei weitergehende Schädigungen der Oberfläche weitestgehend vermeiden.

### 2. i-PERC Ansatz:

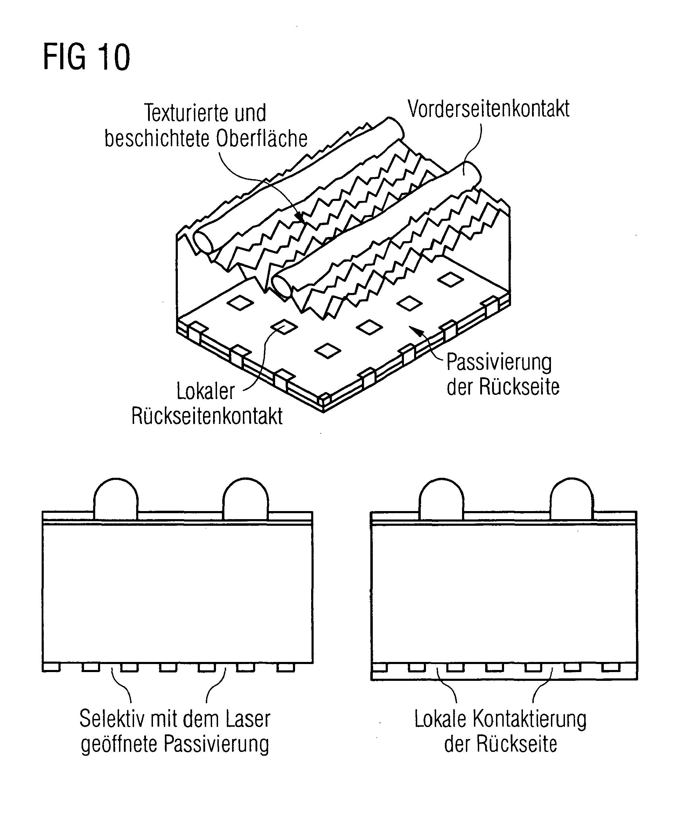

Um den Wirkungsgrad der Standard Siebdrucksolarzellen zu steigern wird auf der Rückseite über eine dielektrische Schicht passiviert. Um die Rückseite kontaktieren zu können, muss diese Passivierungsschicht lokal geöffnet werden und im Anschluss eine Metallschicht aufgebracht werden. Wie auch auf der Vorderseite ist hierbei eine möglichst geringe Schädigung wünschenswert, welche vor allem durch den Einsatz des erfindungsgemäßen Verfahrens, d.h. durch eine homogene Intensitätsverteilung erreicht wird. Die Öffnung kann sowohl durch einen einzelnen Laserpuls als auch durch eine photolithographisch strukturierte Ätzbarriere und nasschemisches Ätzen erreicht werden (siehe Fig. 10, die eine schematische Darstellung einer Solarzelle mit passivierter Rückseite und lokalen Rückseitenkontakten darstellt).

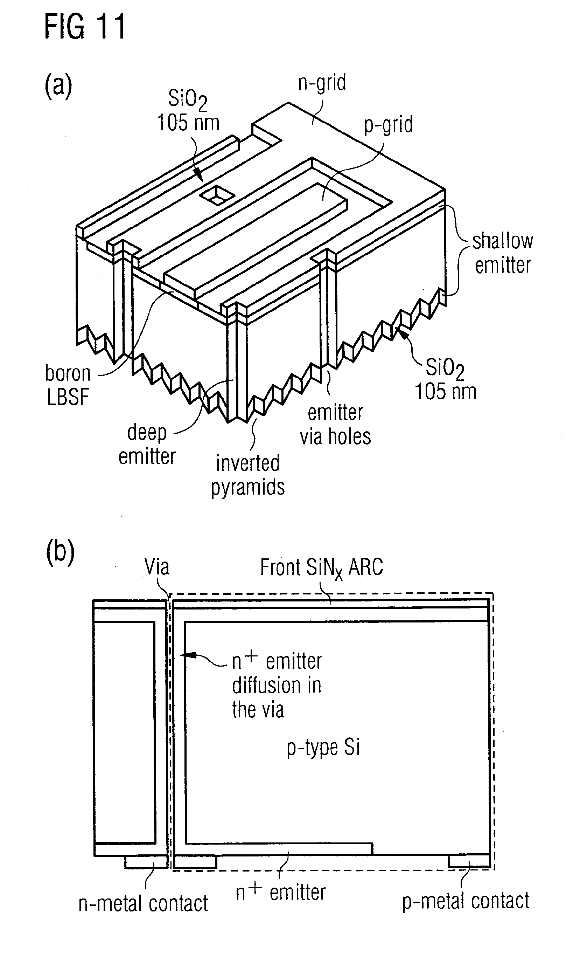

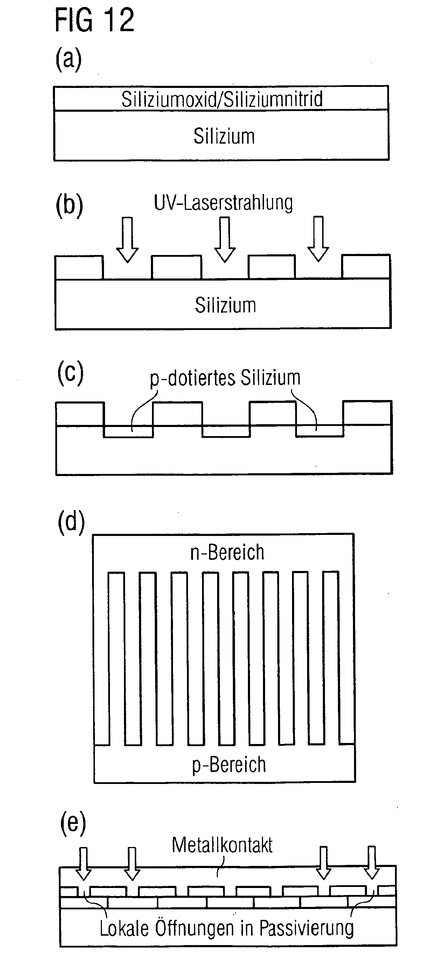

Strukturierung von Ätz- und Diffusionsbarrieren Für die Herstellung rückseitig kontaktierter Solarzellen wie der Emitter-Wrap-Through-Zelle (EWT) befinden sich sowohl p-dotierte und n-dotierte Bereiche auf der Rückseite der Solarzelle (siehe Fig. 11a und b: In Fig. 11a ist der Aufbau einer EWT-Solarzelle mit strukturierter Rückseite und Löchern, welche den Vorderseitenemitter mit den n-Kontakten auf der Rückseite verbinden, dargestellt. Fig. 11b zeigt den Querschnitt einer solchen EWT-Zelle (3)). Um eine solche Struktur zu erzeugen kann eine dielektrische Schicht beispielsweise aus Siliziumoxid oder Siliziumnitrid auf die Oberfläche aufgebracht werden (siehe Fig. 12). Hier ist die Prozessabfolge für die Herstellung der p- und n- Gebiete für Rückseitenkontakt-Zellen dargestellt. (a) zeigt den Ausgangswafer mit einer passivierenden Siliziumoxid- oder Siliziumnitrid-Schicht. Diese Schicht wird in (b) durch Laserablation lokal geöffnet und anschließend (c) durch eine Bor-Diffusion p-dotiert. (d) zeigt die verschränkten Rückseitenstruktur aus p- und n-Gebieten von oben, die durch die Wiederholung der vorausgegangen Schritte entsteht. In (e) wird schematisch dargestellt, wie die Laserablation lokal die Passivierungsschicht öffnet und einen Kontakt zum Metall ermöglicht. Diese Schichten können als Ätz- beziehungsweise Diffusionsbarrieren eingesetzt werden. Lokale Strukturen erfordern auch strukturierte Barrieren, diese können durch photolithographische Strukturierung, einem Druck von Barrieren erreicht werden. Durch die Verwendung des erfindungsgemäßen Verfahrens können allerdings weitergehende Schädigungen der Oberfläche vermieden werden.

## Patentansprüche

1. Verfahren zum Materialabtrag an Festkörpern mittels Laserablation, bei dem die räumliche und/oder zeitliche Kohärenz der zum Materialabtrag eingesetzten Laserstrahlung vor und/oder unmittelbar beim Auftreffen auf den Festkörper herabgesetzt wird.

2. Verfahren nach einem der vorhergehenden Ansprüche, **dadurch gekennzeichnet, dass** die räumliche und/oder zeitliche Kohärenz der Laserstrahlung
a) durch Transmission der Laserstrahlung durch ein die Laserstrahlung streuendes Medium,
b) durch Reflexion der Laserstrahlung an einem die Laserstrahlung streuenden Medium und/oder
c) durch relative Bewegung der Quelle der Laserstrahlung und des Festkörpers während des Ablationsvorganges
herabgesetzt wird.

3. Verfahren nach vorhergehendem Anspruch, **dadurch gekennzeichnet, dass**
a) das streuende Medium ausgewählt ist aus der Gruppe bestehend aus die Laserstrahlung streuenden Partikeln oder partikelhaltigen Systemen, insbesondere in Form von die Laserstrahlung streuenden Pulvern oder Dispersionen und/oder Emulsionen und/oder Lösungen der Partikel, und/oder
b) das reflektierende Medium ausgewählt ist aus der Gruppe bestehend aus die Laserstrahlung streuende Platten.

4. Verfahren nach vorhergehendem Anspruch, **dadurch gekennzeichnet, dass** die Partikel
a) SiO₂ oder TiO₂-Partikel oder Gemische hiervon sind, und/oder
b) einen mittleren Teilchendurchmesser d₅₀ aufweisen, der zwischen dem 0,1- und 10-fachen, bevorzugt zwischen dem 0,3- und 3-fachen, besonders bevorzugt zwischen dem 0,5- und 1-fachen der Wellenlänge des verwendeten Laserlichts liegt.

5. Verfahren nach einem der beiden vorhergehenden Ansprüche, **dadurch gekennzeichnet, dass** vor der Laserablation die Partikel als Pulver oder Dispersion auf die zu bearbeitende Oberfläche des Festkörpers aufgetragen werden.

6. Verfahren nach vorhergehendem Anspruch, **dadurch gekennzeichnet, dass** die Dispersion durch spincoating und/oder dip-coating aufgetragen oder aufgesprüht wird.

7. Verfahren nach einem der vorhergehenden Ansprüche, **dadurch gekennzeichnet, dass** der Festkörper zumindest in dem Bereich, in dem der Materialabtrag durchgeführt wird, zumindest stellenweise eine regelmäßig strukturierte Oberfläche aufweist, insbesondere eine pyramidenförmige Strukturierung.

8. Verfahren nach vorhergehendem Anspruch, **dadurch gekennzeichnet, dass** die Strukturierung eine Periodizität zwischen 1 und 100 µm, bevorzugt zwischen 5 und 50 µm, insbesondere zwischen 5 und 15 µm aufweist.

9. Verfahren nach einem der vorhergehenden Ansprüche, **dadurch gekennzeichnet, dass** der Festkörper ein Halbleiter, bevorzugt ein Siliciumwafer, insbesondere eine eine Antireflexbeschichtung aufweisende Solarzelle ist, wobei der Materialabtrag auf der die Antireflexbeschichtung aufweisende Seite der Solarzelle erfolgt.

10. Verfahren nach einem der vorhergehenden Ansprüche, **dadurch gekennzeichnet, dass** die eingesetzte Laserstrahlung
a) eine Pulslänge zwischen 200 fs und 1000 ns, bevorzugt zwischen 400 fs und 100 ns
b) eine Wellenlänge zwischen 100 und 10.000 nm, bevorzugt 150 und 5.000 nm, besonders bevorzugt zwischen 193 und 1.064 nm, und/oder
c) eine Intensität zwischen 0,1 und 10.000 kJ/m², bevorzugt zwischen 1 und 1.000 kJ/m², besonders bevorzugt zwischen 1 und 100 kJ/m²
aufweist.

11. Verfahren nach einem der vorhergehenden Ansprüche, **dadurch gekennzeichnet, dass** mindestens zwei Laser mit verschiedenen Wellenlängen verwendet werden, wobei ausgehend von einem Zustand gleicher erster Phase aller Wellen frühestens nach dem 5-fachen, bevorzugt frühestens nach dem 25-fachen, besonders bevorzugt frühestens nach dem 50-fachen der Periode je einer Welle mit einer kleineren Wellenlänge diese Welle erneut den gleichen Zustand erster Phase gemeinsam mit allen Wellen größerer Wellenlänge aufweist.

12. Verfahren nach einem der vorhergehenden Ansprüche, **dadurch gekennzeichnet, dass** die Laserquelle ausgewählt ist aus der Gruppe bestehend aus CO₂-Lasern HeNe-Lasern, Excimer-Lasern, Farbstofflasern, Diodenlasern, Faserlasern und/oder Festkörperlasern.

13. Verfahren nach einem der vorhergehenden Ansprüche, **dadurch gekennzeichnet, dass** nach dem Materialabtrag eine zumindest teilweise Befüllung des beim Materialabtrag entstandenen Hohlraumes mit einem elektrisch leitfähigen Material erfolgt.
